# EUROPEAN PATENT APPLICATION

(11) **EP 4 679 524 A1**
(43) Date of publication of application: **14.01.2026**
(21) Application number: 24838284.8
(22) Date of filing: 05.02.2024
(51) Int. Cl.: H01M 4/36, H01M 4/04, H01M 4/525, H01M 4/58, H01M 10/0525

(54) **POSITIVE ELECTRODE ACTIVE MATERIAL, PREPARATION METHOD THEREFOR, BATTERY CELL AND ELECTRICAL APPARATUS**

(30) Priority: 07.07.2023 CN 202310833063
(71) Applicant: Contemporary Amperex Technology Co., Limited, Ningde, Fujian 352100 (CN)
(72) Inventor: LENG, Xue, Ningde, Fujian 352100 (CN); HE, Siyuan, Ningde, Fujian 352100 (CN); BIE, Changfeng, Ningde, Fujian 352100 (CN); LIU, Hongyu, Ningde, Fujian 352100 (CN); NI, Huan, Ningde, Fujian 352100 (CN); LIU, Na, Ningde, Fujian 352100 (CN)
(74) Representative: Lorenz Seidler Gossel Part. mbB
(86) International application number: PCT/CN2024/075972
(87) International publication number: WO 2025/011022

(57) **Abstract**

The present application discloses a positive electrode active material, a preparation method thereof, a battery cell, and a power consuming apparatus. The positive electrode active material includes a lithium-containing phosphate, a charge capacity per gram of the positive electrode active material at 25°C is denoted as C1, the charge capacity per gram of the positive electrode active material at 60°C is denoted as C2, both units are mAh/g, and C2/C1≥1.020. The positive electrode active material provided in the present application can improve a cycle performance of a battery.

## Description

### CROSS-REFERENCE TO RELATED APPLICATIONS

The present application claims priority to Chinese Patent Application No. 202310833063.4, filed with the China National Intellectual Property Administration on July 7, 2023 and entitled "POSITIVE ELECTRODE ACTIVE MATERIAL, PREPARATION METHOD THEREOF, BATTERY CELL, AND POWER CONSUMING APPARATUS", which is incorporated herein by reference in its entirety.

### TECHNICAL FIELD

The present application relates to a positive electrode active material, a preparation method thereof, a battery cell, and a power consuming apparatus.

### BACKGROUND

In recent years, batteries are widely applied to energy storage power stations, for example, have increasing requirements for peak and valley regulation of power grids. Therefore, requirements for the cycle life of energy storage batteries are also increasingly high. However, how to enable batteries to have a longer cycle life is still a difficulty in current battery development.

### SUMMARY

The present application provides a positive electrode active material, a preparation method thereof, a battery cell, and a power consuming apparatus, which can improve a cycle performance of battery.

According to a first aspect of the present application, a positive electrode active material is provided. The positive electrode active material includes a lithium-containing phosphate. A charge capacity per gram of the positive electrode active material at 25°C is denoted as C1, the charge capacity per gram of the positive electrode active material at 60°C is denoted as C2, both units are mAh/g, and C2/C1≥1.020.

The positive electrode active material provided in the present application has a relatively low charge capacity per gram at 25°C and a relatively high charge capacity per gram at 60°C, thus indicating that the positive electrode active material has a relatively high initial capacity. However, a part of the initial capacity is not exerted when a battery is initially charged, but is gradually released in a battery cycle process. Therefore, the positive electrode active material provided in the present application may achieve an effect of a capacity slow-releasing agent, so that the battery using the positive electrode active material has a long cycle life.

In any example, 1.025≤C2/C1≤1.115, and optionally, 1.031≤C2/C1≤1.061. Therefore, the cycle life of the battery may be further prolonged, and the battery may also have a high initial capacity.

In any example, at least a part of a surface of the lithium-containing phosphate has a carbon coating layer.

In any example, the carbon coating layer includes a first carbon coating layer and a second carbon coating layer, and the first carbon coating layer is located between the lithium-containing phosphate and the second carbon coating layer.

In any example, a weight content of the first carbon coating layer is denoted as w1%; and based on a total weight of the positive electrode active material, 0.5≤w1≤2.0, and optionally, 1.06≤w1≤1.38. When the weight content of the first carbon coating layer falls within the foregoing range, on the one hand, an electronic conductivity of the lithium-containing phosphate can be improved; and on the other hand, a specific surface area of the positive electrode active material can be reduced, and a processing performance of a positive electrode slurry and the positive electrode plate can be improved.

In any example, the weight content of the second carbon coating layer is denoted as w2%; and based on the total weight of the positive electrode active material, w2>0, optionally, 0.04≤w2≤0.40, and more optionally, 0.07≤w2≤0.19. When the weight content of the second carbon coating layer falls within the foregoing range, on the one hand, a part of the initial capacity of the positive electrode active material may be hidden; and on the other hand, the positive electrode active material may also have a high initial capacity and a good dynamic performance.

In any example, the weight content of the first carbon coating layer is denoted as w1%, and the weight content of the second carbon coating layer is denoted as w2%; and both based on the total weight of the positive electrode active material, 1.14≤w1+w2≤1.55, and optionally, 1.20≤w1+w2≤1.48. When a sum of the weight content w1% of the first carbon coating layer and the weight content w2% of the second carbon coating layer falls within the foregoing range, the electronic conductivity of the lithium-containing phosphate can be improved, and it is further conducive to hiding a part of the initial capacity of the positive electrode active material. Therefore, it is beneficial for the positive electrode active material to achieve an effect of a capacity slow-releasing agent, so that the battery using the positive electrode active material has a longer cycle life. In addition, when the sum of the weight content w1% of the first carbon coating layer and the weight content w2% of the second carbon coating layer falls within the foregoing range, the positive electrode active material may further have a good dynamic performance, thereby being conducive to reducing the internal resistance of the battery and improving the power performance and energy conversion efficiency of the battery.

In any example, the weight content of the first carbon coating layer is denoted as w1%, and the weight content of the second carbon coating layer is denoted as w2%; and both based on the total weight of the positive electrode active material, 0.030≤w2/w1≤0.240, and optionally, 0.072≤w2/w1≤0.152. When a ratio w2/w1 of the weight content w1% of the first carbon coating layer to the weight content w2% of the second carbon coating layer falls within the foregoing range, the electronic conductivity of the lithium-containing phosphate can be improved, and it is further conducive to hiding a part of the initial capacity of the positive electrode active material. Therefore, it is beneficial for the positive electrode active material to achieve an effect of a capacity slow-releasing agent, so that the battery using the positive electrode active material has a longer cycle life. In addition, when the ratio w2/w1 of the weight content w1% of the first carbon coating layer to the weight content w2% of the second carbon coating layer falls within the foregoing range, the positive electrode active material may further have a good dynamic performance, thereby being conducive to reducing the internal resistance of the battery and improving the power performance and energy conversion efficiency of the battery.

In any example, the first carbon coating layer includes pyrolytic carbon formed by way of pyrolysis, and the second carbon coating layer includes chemical vapor deposition carbon formed by way of chemical vapor deposition.

In any example, a graphitization degree of the first carbon coating layer is less than a graphitization degree of the second carbon coating layer. Therefore, the electronic conductivity of the lithium-containing phosphate can be improved, and a part of the initial capacity of the positive electrode active material can also be hidden, so that the positive electrode active material can achieve an effect of a capacity slow-releasing agent. Therefore, the battery using the positive electrode active material has a long cycle life, a good power performance and a high energy conversion efficiency.

In any example, the positive electrode active material is of a single-crystal structure or a quasi-single-crystal structure.

In any example, a volume distribution particle size Dv50 of the positive electrode active material ranges from 0.5 µm to 2.5 µm, and optionally ranges from 1.3 µm to 1.9 µm.

In any example, 145mAh/g≤C1≤162mAh/g, and optionally, 152.5 mAh/g≤C1≤156.7 mAh/g.

In any example, 158mAh/g≤C2≤167mAh/g, and optionally, 160.0 mAh/g≤C2≤162.8 mAh/g.

When the charge capacity C1 per gram of the positive electrode active material at 25°C and/or the charge capacity C2 per gram of the positive electrode active material at 60°C are within the foregoing range, the battery may have a long cycle life, and the battery may also have a relatively high energy density.

In any example, the lithium-containing phosphate includes one or more of lithium iron phosphate and doped modified compounds thereof.

In any example, the lithium-containing phosphate includes a material with a molecular formula LiₘAₓFe_{1-y}B_{y}P_{1-z}C_{z}O₄₋ₙDₙ, where A includes one or more elements of Zn, AI, Na, K, and Mg; B includes one or more elements of Cu, Mn, Cr, Zn, Pb, Ca, Co, Ni, Sr, Nb, and Ti; C includes one or more elements of B, S, Si, and N; D includes one or more elements of S, F, Cl, and Br; m is selected from a range of 0.5 to 1.15, and is optionally selected from a range of 0.95 to 1.05; x is selected from a range of 0 to 0.1, and is optionally selected from a range of 0.001 to 0.005; y is selected from a range of 0 to 0.5, and is optionally selected from a range of 0.001 to 0.1; z is selected from a range of 0 to 0.5, and is optionally selected from a range of 0.001 to 0.1; and n is selected from a range of 0 to 0.5, and is optionally selected from a range of 0.001 to 0.1.

According to a second aspect of the present application, a preparation method of a positive electrode active material is provided, including the following steps: providing a lithium-containing phosphate precursor; grinding the lithium-containing phosphate precursor and a first carbon source, heating a ground material to a first temperature T1 in a protective gas atmosphere, and keeping the ground material at the first temperature T1 for a first time t1 to obtain a lithium-containing phosphate coated with a first carbon coating layer; and placing the obtained lithium-containing phosphate coated with a first carbon coating layer in a chemical vapor deposition device, heating the obtained lithium-containing phosphate to a second temperature T2 in the protective gas atmosphere, introducing deposition gas, and then, keeping the obtained lithium-containing phosphate at the second temperature T2 for a second time t2 to enable the deposition gas to deposit to form a second carbon coating layer, so as to obtain a positive electrode active material. The positive electrode active material includes the lithium-containing phosphate, a charge capacity per gram of the positive electrode active material at 25°C is denoted as C1, the charge capacity per gram of the positive electrode active material at 60°C is denoted as C2, both units are mAh/g, and C2/C1≥1.020.

In any example, in the step of grinding the lithium-containing phosphate precursor and a first carbon source, a volume distribution particle size Dv50 of the ground material ranges from 350 nm to 500 nm, and optionally ranges from 350 nm to 450 nm. When the volume distribution particle size Dv50 of the ground material falls within the foregoing range, particles of the positive electrode active material may have a suitable primary particle (the primary particles herein are primary particles of quasi-single-crystal particles) size, so that the positive electrode active material may have a good dynamic performance, and a part of the initial capacity of the positive electrode active material may be hidden. Therefore, the positive electrode active material may achieve an effect of a capacity slow-releasing agent, and thus, a cycle performance and a power performance of the battery may be improved.

In any example, the first temperature T1 ranges from 760°C to 850°C, and optionally ranges from 780°C to 820°C. When the first temperature T1 falls within the foregoing range, the particles of the positive electrode active material may have a suitable primary particle (the primary particles herein are primary particles of quasi-single-crystal particles) size, so that the positive electrode active material may have a good dynamic performance, and a part of the initial capacity of the positive electrode active material may be hidden. Therefore, the positive electrode active material may achieve an effect of a capacity slow-releasing agent, and thus, the cycle performance and the power performance of the battery may be improved.

In any example, the first time t1 ranges from 8 h to 15 h, and optionally ranges from 10 h to 14 h. When the first time t1 falls within the foregoing range, the particles of the positive electrode active material may have a suitable primary particle (the primary particles herein are primary particles of quasi-single-crystal particles) size, so that the positive electrode active material may have a good dynamic performance, and a part of the initial capacity of the positive electrode active material may be hidden. Therefore, the positive electrode active material may achieve an effect of a capacity slow-releasing agent, and thus, the cycle performance and the power performance of the battery may be improved.

In any example, the second temperature T2 ranges from 600°C to 800°C, and optionally ranges from 700°C to 800°C. When the second temperature T2 falls within the foregoing range, the positive electrode active material may have a good dynamic performance, the positive electrode active material may also better achieve an effect of a capacity slow-releasing agent, and thus, the cycle performance and the power performance of the battery may be better improved.

In any example, a flow rate of the deposition gas is denoted as V, and a unit is L/min; a mass of the lithium-containing phosphate coated with a first carbon coating layer in the chemical vapor deposition device is denoted as m, and a unit is kg; (V×t2)/m>0, and a unit of the second time t2 is min; and optionally, (V×t2)/m ranges from 0.375 to 3.750, and more optionally ranges from 0.750 to 1.500. By adjusting the flow rate of the deposition gas, the second time t2, and the mass m of the used lithium-containing phosphate coated with a first carbon coating layer to satisfy the foregoing relational expression, the content of the second carbon coating layer may be adjusted to be within a suitable range.

In any example, the first carbon source includes one or more of glucose, sucrose, lactose, maltose, starch, cellulose, asphalt, polyethylene glycol, and carbon black.

In any example, the deposition gas includes one or more of acetylene, methane, ethylene, propylene, benzene, and toluene.

In any example, the protective gas includes one or more of nitrogen, argon, and helium.

According to a third aspect of the present application, a battery cell is provided, including a positive electrode plate. The positive electrode plate includes a positive electrode current collector and a positive electrode film layer arranged on at least one surface of the positive electrode current collector. The positive electrode film layer includes the positive electrode active material according to the first aspect of the present application, or the positive electrode active material prepared by the preparation method according to the second aspect of the present application.

According to a fourth aspect of the present application, a power consuming apparatus is provided, including the battery cell according to the third aspect of the present application.

The power consuming apparatus in the present application includes the battery cell provided in the present application, and therefore has at least the same advantages as the battery cell.

### BRIEF DESCRIPTION OF THE DRAWINGS

To describe the technical solutions of the examples of the present application more clearly, a brief introduction to the accompanying drawings required for use in examples of the present application will be provided below. Obviously, the accompanying drawings described below are merely some embodiments of the present application. Those skilled in the art may further derive other accompanying drawings from such accompanying drawings without making any creative efforts.
FIG. 1 is a schematic diagram of an embodiment of a battery cell according to the present application;
FIG. 2 is a schematic exploded view of the embodiment of the battery cell shown in FIG. 1;
FIG. 3 is a schematic diagram of an embodiment of a battery module according to the present application;
FIG. 4 is a schematic diagram of an embodiment of a battery pack according to the present application;
FIG. 5 is a schematic exploded view of the embodiment of the battery pack shown in FIG. 4; and
FIG. 6 is a schematic diagram of an embodiment of a power consuming apparatus including a battery of the present application as a power source.

In the accompanying drawings, the accompanying drawings are not drawn to actual scale. Description of reference numerals: 1, battery pack; 2, upper box; 3, lower box; 4, battery module; 5, battery cell; 51, case; 52, electrode assembly; and 53, cover plate.

### DETAILED DESCRIPTION

Hereinafter, the embodiments that specifically disclose a positive electrode active material, a preparation method thereof, a battery cell, and a power consuming apparatus of the present application will be described in detail with reference to the accompanying drawings as appropriate. However, there may be situations where unnecessary detailed descriptions are omitted. For example, there are situations where detailed descriptions of well-known items and repeated descriptions of actually identical structures are omitted. Thus, the following descriptions do not become unnecessarily lengthy, which facilitates understanding by those skilled in the art. In addition, the accompanying drawings and the following descriptions are provided for those skilled in the art to fully understand the present application, and are not intended to limit the subject matter recited in the claims.

The "ranges" disclosed in the present application are defined in the form of lower and upper limits, with a given range being defined by the selection of a lower limit and an upper limit defining the boundaries of the particular range. The range defined in this way may include or exclude end values, and may be arbitrarily combined, that is, any lower limit can be combined with any upper limit to form a range. For example, if ranges of 60 to 120 and 80 to 110 are listed for a particular parameter, it is to be understood that ranges of 60 to 110 and 80 to 120 are also expected. Additionally, if the minimum range values 1 and 2 and the maximum range values 3, 4 and 5 are listed, the following ranges are all expected: 1 to 3, 1 to 4, 1 to 5, 2 to 3, 2 to 4, and 2 to 5. In the present application, unless otherwise specified, the numerical range "a to b" represents an abbreviated representation of any combination of real numbers between a and b, where both a and b are real numbers. For example, the numerical range "0 to 5" means that all real numbers between "0 and 5" are listed herein, and "0 to 5" is merely an abbreviated representation of the combination of these numbers. In addition, when a parameter is expressed as an integer greater than or equal to 2, it is equivalent to disclosing that the parameter is an integer such as 2, 3, 4, 5, 6, 7, 8, 9, 10, 11, 12, or the like.

Unless otherwise specified, all the embodiments and optional embodiments of the present application can be combined with each other to form new technical solutions, and such technical solutions should be considered to be included in the disclosure of the present application.

Unless otherwise specified, all the technical features and optional technical features of the present application can be combined with each other to form new technical solutions, and such technical solutions should be considered to be included in the disclosure of the present application.

Unless otherwise specified, all the steps in the present application can be performed in the order described or in a random order, and preferably in the order described. For example, the method includes steps (a) and (b), meaning that the method may include steps (a) and (b) performed sequentially, or may include steps (b) and (a) performed sequentially. For example, the reference to "the method may further include step (c)" indicates that step (c) may be added to the method in any order, e.g., the method may include steps (a), (b) and (c), or steps (a), (c) and (b), or steps (c), (a) and (b), or the like.

Unless otherwise specified, in the present application, the terms "first", "second", and the like are used to distinguish different objects, rather than to describe a specific order or primary-secondary relationship.

In the present application, the term "a plurality of" or "a plurality of types of" indicates two or more.

In the description of the examples of the present application, unless otherwise specified, the first feature being located "above" or "below" the second feature may be the first feature being in direct contact with the second feature, or the first feature being in indirect contact with the second feature through an intermediate medium. In addition, that the first feature is located "above", "over", or "on" the second feature may indicate that the first feature is directly located over or obliquely located over the second feature, or may merely indicate that the horizontal position of the first feature is higher than that of the second feature. That the first feature is located "below", "under", and "beneath" the second feature may indicate that the first feature is directly located under the second feature or obliquely located under the second feature, or may merely indicate that the horizontal position of the first feature is lower than that of the second feature.

Unless otherwise specified, the terms used in the present application have well-known meanings as commonly understood by those skilled in the art.

Unless otherwise specified, the values of the parameters mentioned in the present application can be measured by various test methods commonly used in the art, for example, can be measured according to the test methods given in the examples of the present application. Unless otherwise specified, a test temperature of each parameter is 25°C.

A battery mentioned in examples of the present application may be a single physical module including one or more battery cells to provide a higher voltage and a higher capacity. For example, the battery provided in the present application may include a battery cell, a battery module, a battery pack, or the like.

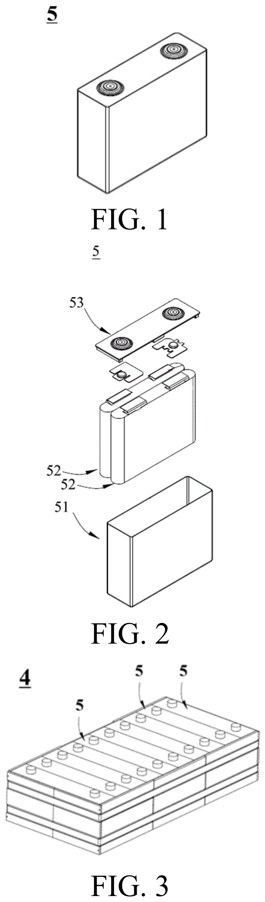

The battery cell is the smallest unit constituting the battery, and can achieve functions of charging and discharging independently. The battery cell may be in a cylinder shape, a cuboid shape or other shapes, which is not limited in the examples of the present application. FIG. 1 shows a battery cell 5 having a cuboid structure as an example.

When a plurality of battery cells are provided, the plurality of battery cells are connected in series, in parallel or in series and parallel through bus components. In some examples, the battery may be a battery module. When a plurality of battery cells are provided, the plurality of battery cells are arranged and fixed to form a battery module. In some examples, the battery may be a battery pack, the battery pack includes a box body and a battery cell, and the battery cell or the battery module is accommodated in the box body. In some examples, the box body may be used as a part of a chassis structure of a vehicle. For example, a part of the box body may become at least a part of a bottom plate of the vehicle, or a part of the box body may become at least a part of a cross beam and a longitudinal beam of the vehicle.

In some examples, the battery may be an energy storage apparatus. The energy storage apparatus includes an energy storage container, an energy storage electric cabinet, and the like.

The battery cell generally includes an electrode assembly. The electrode assembly usually includes a positive electrode plate and a negative electrode plate, and the electrode assembly may be of a wound structure or a stacked structure, which is not limited in the examples of the present application.

The battery cell may further include an outer package, and the outer package may be configured to encapsulate the electrode assembly and the electrolyte solution. The outer package may be a hard shell, for example, a hard plastic shell, an aluminum shell, or a steel shell. The outer package may also be a soft pack, for example, a pouch type soft pack. The soft pack may be made from plastic, for example, one or more of polypropylene (PP), polybutylene terephthalate (PBT), and polybutylene succinate (PBS).

In some examples, as shown in FIG. 2, the outer package may include a case 51 and a cover plate 53. The case 51 may include a bottom plate and a side plate connected to the bottom plate. The bottom plate and the side plate enclose an accommodating cavity. The case 51 is provided with an opening in communication with the accommodating cavity, and the cover plate 53 is configured to cover the opening to close the accommodating cavity. The electrode assembly 52 is encapsulated in the accommodating cavity. One or more electrode assemblies 52 may be included in the battery cell 5, which may be adjusted as required.

In some examples, the battery cells may be assembled into a battery module, the battery module may include a plurality of battery cells, and the specific number of battery cells may be adjusted according to the application and capacity of the battery module. FIG. 3 is a schematic diagram of a battery module 4 as an example. As shown in FIG. 3, in the battery module 4, a plurality of battery cells 5 may be arranged sequentially along a length direction of the battery module 4. Of course, the plurality of battery cells may also be arranged in any other ways. The plurality of battery cells 5 may further be fixed by fasteners.

Optionally, the battery module 4 may further include a shell having an accommodating space, and the plurality of battery cells 5 are accommodated in the accommodating space.

In some examples, the foregoing battery modules may further be assembled into a battery pack, and the number of the battery modules included in the battery pack may be adjusted according to the application and capacity of the battery pack.

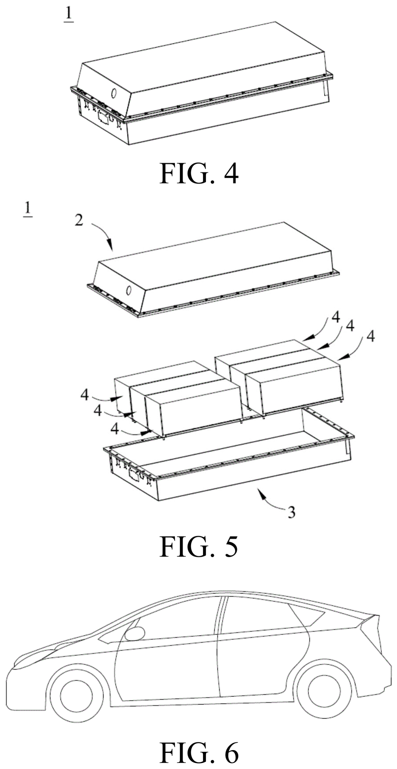

FIG. 4 and FIG. 5 are schematic diagrams of a battery pack 1 as an example. As shown in FIG. 4 and FIG. 5, the battery pack 1 may include a box body and a plurality of battery modules 4 arranged in the box body. The box body includes an upper box 2 and a lower box 3. The upper box 2 is configured to cover the lower box 3 and form an enclosed space for accommodating the battery modules 4. The plurality of battery modules 4 may be arranged in the box body in any manner.

To improve the cycle life of a battery, a strategy usually used at present is lithium supplementation. However, large-scale industrialization of the lithium supplementation technology further needs technical progress, and both lithium supplementation of the positive electrode and lithium supplementation of the negative electrode have relatively low utilization of lithium, and also increase the cost.

Another common strategy is to add some additives to the electrolyte solution. The principle of the additive is usually to form a dense SEI film on the negative electrode or form a dense CEI film on the positive electrode. However, this usually worsens a dynamic performance of the battery, thereby reducing the energy conversion efficiency, and also limiting the improvement on the cycle life of the battery.

In view of this, the inventor provides a new positive electrode active material, which enables a battery using the new positive electrode active material to have a long cycle life.

The positive electrode active material provided in this example of the present application includes a lithium-containing phosphate. A charge capacity per gram of the positive electrode active material at 25°C is denoted as C1, the charge capacity per gram of the positive electrode active material at 60°C is denoted as C2, both units are mAh/g, and C2/C1≥1.020.

The positive electrode active material provided in this example of the present application has a relatively low charge capacity per gram at 25°C and a relatively high charge capacity per gram at 60°C, thus indicating that the positive electrode active material has a relatively high initial capacity. However, a part of the initial capacity is not exerted when a battery is initially charged, but is gradually released in a battery cycle process. Therefore, the positive electrode active material provided in this example of the present application may achieve an effect of a capacity slow-releasing agent, so that the battery using the positive electrode active material has a long cycle life.

In some examples, 1.02≤C2/C1≤1.20, optionally, 1.025≤C2/C1≤1.115, and more optionally, 1.031≤C2/C1≤1.061. Therefore, the cycle life of the battery may be further prolonged, and the battery may also have a high initial capacity.

In some examples, 145 mAh/g≤C1≤162 mAh/g, optionally, 152 mAh/g≤C1≤161 mAh/g, and more optionally, 152.5 mAh/g≤C1≤156.7 mAh/g.

In some examples, 158 mAh/g≤C2≤167 mAh/g, optionally, 159 mAh/g≤C2≤164 mAh/g, and more optionally, 160.0 mAh/g≤C2≤162.8 mAh/g.

When the charge capacity C1 per gram of the positive electrode active material at 25°C and/or the charge capacity C2 per gram of the positive electrode active material at 60°C are within the foregoing range, the battery may have a long cycle life, and the battery may also have a relatively high energy density.

It should be noted that the test for the charge capacity per gram of the positive electrode active material in the examples of the present application may be conducted by sampling and analyzing in a preparation process of a positive electrode plate, or by sampling and testing from a prepared battery.

In a test process, the positive electrode plate containing the positive electrode active material provided in the examples of the present application and a lithium metal sheet (used as a counter electrode) may be assembled to form a button battery, such as CR2430 for testing. Test conditions are as follows: At 25°C, the button battery is allowed to stand for 3 h, charged to an upper limit of a cut-off voltage at a constant current of 0.1 C, then charged to 50 µA at a constant voltage, and allowed to stand for 5 min, and the charge capacity of the button battery is recorded. Charge capacity C1 per gram of positive electrode active material at 25°C=charge capacity of button battery at 25°C/mass of positive electrode active material in button battery. At 60°C, the button battery is allowed to stand for 3 h, charged to an upper limit of a cut-off voltage at a constant current of 0.1 C, then charged to 50 µA at a constant voltage, and allowed to stand for 5 min, and the charge capacity of the button battery is recorded. Charge capacity C2 per gram of positive electrode active material at 60°C=charge capacity of button battery at 60°C/mass of positive electrode active material in button battery. When positive electrode active materials are lithium iron phosphate (LiFePO₄) and doped modified compounds thereof, the upper limit of the cut-off voltage during the foregoing test may be 3.75 V.

Exemplarily, the button battery may be prepared according to the following method: a lithium metal sheet is used as a counter electrode, a solution of 1 mol/L LiPF₆ in ethylene carbonate (EC), diethyl carbonate (DEC), and ethyl methyl carbonate (EMC) at a volume ratio of 1:1:1 is used as an electrolyte solution, and the lithium metal sheet and the solution are assembled together with the positive electrode plate containing the positive electrode active material provided in the examples of the present application in a button battery box to form the button battery.

The positive electrode plate may also be disassembled from the prepared battery and then assembled into a button battery, and the charge capacity C1 per gram of the positive electrode active material at 25°C and the charge capacity C2 per gram of the positive electrode active material at 60°C may be tested according to the foregoing test method.

In some examples, at least a part of a surface of the lithium-containing phosphate has a carbon coating layer.

In some examples, the carbon coating layer may include a first carbon coating layer and a second carbon coating layer, and the first carbon coating layer is located between the lithium-containing phosphate and the second carbon coating layer.

In some examples, the first carbon coating layer may include pyrolytic carbon formed by way of pyrolysis, and the second carbon coating layer may include chemical vapor deposition carbon formed by way of chemical vapor deposition.

The charge capacity C1 per gram of the positive electrode active material at 25°C and the charge capacity C2 per gram of the positive electrode active material at 60°C may be adjusted by adjusting the composition of the carbon coating layer.

The first carbon coating layer is located between the lithium-containing phosphate and the second carbon coating layer, and the first carbon coating layer includes pyrolytic carbon. The main function of the first carbon coating layer is to improve an electronic conductivity of the lithium-containing phosphate. The second carbon coating layer includes chemical vapor deposition carbon, and the main function of the second carbon coating layer is to perform excessive carbon coating and reduce the contact between the lithium-containing phosphate and the electrolyte solution. Therefore, a part of the initial capacity of the positive electrode active material may be hidden, so that a part of the initial capacity of the positive electrode active material may not be exerted when the battery is initially charged. In addition, in a battery cycle process, the lithium-containing phosphate body is gradually in sufficient contact with the electrolyte solution, so that the hidden part of the initial capacity is gradually released in the battery cycle process. Therefore, the positive electrode active material may achieve an effect of a capacity slow-releasing agent, so that the battery using the positive electrode active material has a long cycle life.

In some examples, a graphitization degree of the first carbon coating layer may be less than a graphitization degree of the second carbon coating layer. Therefore, the electronic conductivity of the lithium-containing phosphate can be improved, and a part of the initial capacity of the positive electrode active material can also be hidden, so that the positive electrode active material can achieve an effect of a capacity slow-releasing agent. Therefore, the battery using the positive electrode active material has a long cycle life, a good power performance and a high energy conversion efficiency.

In some examples, a weight content of the first carbon coating layer is denoted as w1%; and based on a total weight of the positive electrode active material, 0.5≤w1≤2.0, optionally, 1.0≤w1≤1.4, and more optionally, 1.06≤w1≤1.38.

When the weight content of the first carbon coating layer falls within the foregoing range, on the one hand, the electronic conductivity of the lithium-containing phosphate can be improved; and on the other hand, a specific surface area of the positive electrode active material can be reduced, and a processing performance of a positive electrode slurry and the positive electrode plate can be improved.

In some examples, a weight content of the second carbon coating layer is denoted as w2%; and based on the total weight of the positive electrode active material, w2>0.

In some examples, 0.04≤w2≤0.40, optionally, 0.06≤w2≤0.20, and more optionally, 0.07≤w2≤0.19. When the weight content of the second carbon coating layer falls within the foregoing range, on the one hand, a part of the initial capacity of the positive electrode active material may be hidden; and on the other hand, the positive electrode active material may also have a high initial capacity and a good dynamic performance.

In some examples, 1.14≤w1+w2≤1.55, and optionally, 1.20≤w1+w2≤1.48. When a sum of the weight content w1% of the first carbon coating layer and the weight content w2% of the second carbon coating layer falls within the foregoing range, the electronic conductivity of the lithium-containing phosphate can be improved, and it is further conducive to hiding a part of the initial capacity of the positive electrode active material. Therefore, it is beneficial for the positive electrode active material to achieve an effect of a capacity slow-releasing agent, so that the battery using the positive electrode active material has a longer cycle life. In addition, when the sum of the weight content w1% of the first carbon coating layer and the weight content w2% of the second carbon coating layer falls within the foregoing range, the positive electrode active material may further have a good dynamic performance, thereby being conducive to reducing the internal resistance of the battery and improving the power performance and energy conversion efficiency of the battery.

In some examples, 0.030≤w2/w1≤0.240, and optionally, 0.072≤w2/w1≤0.152. When a ratio w2/w1 of the weight content w1% of the first carbon coating layer to the weight content w2% of the second carbon coating layer falls within the foregoing range, the electronic conductivity of the lithium-containing phosphate can be improved, and it is further conducive to hiding a part of the initial capacity of the positive electrode active material. Therefore, it is beneficial for the positive electrode active material to achieve an effect of a capacity slow-releasing agent, so that the battery using the positive electrode active material has a longer cycle life. In addition, when the ratio w2/w1 of the weight content w1% of the first carbon coating layer to the weight content w2% of the second carbon coating layer falls within the foregoing range, the positive electrode active material may further have a good dynamic performance, thereby being conducive to reducing the internal resistance of the battery and improving the power performance and energy conversion efficiency of the battery.

In some examples, the positive electrode active material is of a single-crystal structure or a quasi-single-crystal structure.

In the present application, the term "quasi-single crystal" refers to a particle formed by aggregating a small number of primary particles (for example, no more than 10 primary particles).

The carbon coating layer of the positive electrode active material having the quasi-single-crystal structure not only includes a carbon coating layer located on the overall outer surface of the lithium-containing phosphate, but also includes a carbon coating layer located on the surface of the primary particle forming the quasi-single-crystal structure. Therefore, the weight content w1% of the first carbon coating layer refers to the total weight content of the first carbon coating layer at different positions in the positive electrode active material; and the weight content w2% of the second carbon coating layer refers to the total weight content of the second carbon coating layer at different positions in the positive electrode active material.

In some examples, a volume distribution particle size Dv50 of the positive electrode active material may range from 0.5 µm to 2.5 µm, optionally range from 1.0 µm to 2.3 µm, and more optionally range from 1.3 µm to 1.9 µm. When the volume distribution particle size Dv50 of the positive electrode active material falls within the foregoing range, the positive electrode active material may have good ion transport performance, so that the battery may have a good power performance, and the processing performance of the positive electrode slurry and the positive electrode plate may also be improved. For example, the problems of excessive sticking of the slurry and cracking of the coating may be reduced.

The Dv50 of the positive electrode active material has a meaning well-known in the art, and may be measured by using instruments and methods known in the art. For example, a laser particle size analyzer (for example, Malvern Mastersizer 3000) may be used for measurement with reference to GB/T 19077-2016. The physical definition of Dv50: Dv50 corresponds to the particle size at which the percentage of the cumulative volume distribution of the material reaches 50%.

In some examples, the specific surface area of the positive electrode active material may be less than or equal to 17 m²/g, and optionally may be less than or equal to 14 m²/g. Therefore, the processing performance of the positive electrode slurry and the positive electrode plate may be improved, and the problems of excessive sticking of the slurry and cracking of the coating may be reduced.

The specific surface area of the positive electrode active material has a meaning well-known in the art, and may be measured by using instruments and methods known in the art. For example, with reference to GB/T 19587-2017, a nitrogen adsorption specific surface area analysis test method may be used for testing, and a Brunauer Emmett Teller (BET) method is used for calculation. The test instrument may be a Tri-Star 3020 type specific surface area and pore size analysis tester available from Micromeritics company, the United States.

In some examples, a power resistivity of the positive electrode active material at 25°C may be less than or equal to 15 Ω.cm. When the powder resistivity of the positive electrode active material falls within the foregoing range, the electronic conductivity of the lithium-containing phosphate may be improved, and the hydrophilicity of the lithium-containing phosphate may also be reduced to reduce the absorption of water, so that the cycle performance of the battery may be further improved.

The powder resistivity of the positive electrode active material has a meaning well-known in the art, and may be measured by using instruments and methods known in the art. For example, the test may be performed with reference to GB/T 32993-2016. The test temperature is 25°C.

In some examples, the lithium-containing phosphate may have an olivine structure.

In some examples, the lithium-containing phosphate may include lithium iron phosphate (LiFePO₄) and one or more of doped modified compounds thereof.

In some examples, the lithium-containing phosphate may include a material with a molecular formula LiₘAₓFe_{1-y}B_{y}P_{1-z}C_{z}O₄₋ₙDₙ, where A includes one or more elements of Zn, AI, Na, K, and Mg; B includes one or more elements of Cu, Mn, Cr, Zn, Pb, Ca, Co, Ni, Sr, Nb, and Ti; C includes one or more elements of B, S, Si, and N; D includes one or more elements of S, F, Cl, and Br; m is selected from a range of 0.5 to 1.15, and is optionally selected from a range of 0.95 to 1.05; x is selected from a range of 0 to 0.1, and is optionally selected from a range of 0.001 to 0.005; y is selected from a range of 0 to 0.5, and is optionally selected from a range of 0.001 to 0.1; z is selected from a range of 0 to 0.5, and is optionally selected from a range of 0.001 to 0.1; and n is selected from a range of 0 to 0.5, and is optionally selected from a range of 0.001 to 0.1. Values of m, x, y, z, and n need to keep the lithium-containing phosphate to be electroneutral.

During charging and discharging, the battery is accompanied by deintercalation and consumption of Li; and when the battery is discharged to different states, Li usually has different molar contents. In the list of the lithium-containing phosphate in this example of the present application, the molar content of Li is the molar content of the lithium-containing phosphate in an initial state. When the positive electrode active material is applied to a battery system, after charging and discharging cycles, the molar content of Li usually changes.

### [Preparation method]

An example of the present application further provides a method for preparing the positive electrode active material mentioned above.

The method includes the following steps: provide a lithium-containing phosphate precursor; grind the lithium-containing phosphate precursor and a first carbon source, heat a ground material to a first temperature T1 in a protective gas atmosphere, and keep the ground material at the first temperature T1 for a first time t1 to obtain a lithium-containing phosphate coated with a first carbon coating layer; and place the obtained lithium-containing phosphate coated with a first carbon coating layer in a chemical vapor deposition device, heat the obtained lithium-containing phosphate to a second temperature T2 in the protective gas atmosphere, introduce deposition gas, and then, keep the obtained lithium-containing phosphate at the second temperature T2 for a second time t2 to enable the deposition gas to deposit to form a second carbon coating layer, so as to obtain a positive electrode active material. The positive electrode active material includes the lithium-containing phosphate. A charge capacity per gram of the positive electrode active material at 25°C is denoted as C1, the charge capacity per gram of the positive electrode active material at 60°C is denoted as C2, both units are mAh/g, and C2/C1≥1.020.

The first carbon coating layer includes pyrolytic carbon, and the main function of the first carbon coating layer is to improve the electronic conductivity of the lithium-containing phosphate. The second carbon coating layer includes chemical vapor deposition carbon, and the main function of the second carbon coating layer is to perform excessive carbon coating and reduce the contact between the lithium-containing phosphate and the electrolyte solution. Therefore, a part of the initial capacity of the positive electrode active material may be hidden, so that a part of the initial capacity of the positive electrode active material may not be exerted when the battery is initially charged. In addition, in a battery cycle process, the lithium-containing phosphate body is gradually in sufficient contact with the electrolyte solution, so that the hidden part of the initial capacity is gradually released in the battery cycle process. Therefore, the positive electrode active material may achieve an effect of a capacity slow-releasing agent, so that the battery using the positive electrode active material has a long cycle life.

In some examples, the lithium-containing phosphate precursor may be a mixture of various raw materials for preparing the lithium-containing phosphate, and for example, may include a lithium source, a metal source (such as an iron source), a phosphorus source, and optional various doped element (such as A, B, C, and D) sources.

The lithium source may include one or more of lithium hydroxide, lithium carbonate, lithium phosphate, lithium oxalate, and lithium acetate.

The metal source may include one or more of oxides, hydroxides, halides, phosphates, oxalates, sulfates, carbonates, and nitrates of metal elements.

The phosphorus source may include one or more of phosphoric acid, ammonium dihydrogen phosphate, diammonium hydrogen phosphate, ammonium phosphate, and iron phosphate.

The doped element source may include various compounds containing doped elements.

In some examples, FePO₄ may be used as an iron source and a phosphorus source.

In some examples, the first carbon source may include, but is not limited to, one or more of glucose, sucrose, lactose, maltose, starch, cellulose, asphalt, polyethylene glycol, and carbon black.

An added amount of the first carbon source may be calculated according to a residual carbon value (corresponding to a weight of the first carbon coating layer in the positive electrode active material) of the first carbon source. In some examples, the weight content of the first carbon coating layer (that is, a weight content of a residual carbon of the first carbon source) is denoted as w1%; and based on the total weight of the positive electrode active material, 0.5≤w1≤2.0, optionally, 1.0≤w1≤1.4, and more optionally, 1.06≤w1≤1.38.

In some examples, in the step of grinding the lithium-containing phosphate precursor and a first carbon source, a volume distribution particle size Dv50 of the ground material may range from 350 nm to 500 nm, such as 350 nm, 380 nm, 400 nm, 420 nm, 440 nm, 450 nm, 480 nm, 500 nm, or a range composed of any of the foregoing values.

When the volume distribution particle size Dv50 of the ground material falls within the foregoing range, particles of the positive electrode active material may have a suitable primary particle (the primary particles herein are primary particles of quasi-single-crystal particles) size, so that the positive electrode active material may have a good dynamic performance, and a part of the initial capacity of the positive electrode active material may be hidden. Therefore, the positive electrode active material may achieve an effect of a capacity slow-releasing agent, and thus, a cycle performance and a power performance of the battery may be improved.

When the volume distribution particle size Dv50 of the ground material is relatively large, the dynamic performance of the prepared positive electrode active material is poor. When the volume distribution particle size Dv50 of the ground material is relatively small, the prepared positive electrode active material has a good dynamic performance, but the initial capacity of the positive electrode active material may be sufficiently exerted. It is very difficult to subsequently perform excessive carbon coating. Therefore, it is very difficult for the prepared positive electrode active material to achieve an effect of a capacity slow-releasing agent, so that it is difficult for the battery using the positive electrode active material to have a long cycle life.

Optionally, the volume distribution particle size Dv50 of the ground material may range from 350 nm to 450 nm. Therefore, the cycle performance and the power performance of the battery may be further improved.

In some examples, in the step of grinding the lithium-containing phosphate precursor and a first carbon source, a solvent, such as a mixture of one or more of water, ethanol and propanol, may further be added.

In some examples, after the lithium-containing phosphate precursor and the first carbon source are ground, spray drying may further be performed, and then, a powder after spray drying may be heated to a first temperature T1 in a protective gas atmosphere and kept for a first time t1, so as to obtain a lithium-containing phosphate coated with a first carbon coating layer.

In some examples, the first temperature T1 may range from 760°C to 850°C, such as 760°C, 770°C, 780°C, 790°C, 800°C, 810°C, 820°C, 830°C, 840°C, 850°C, or a range composed of any of the foregoing values.

When the first temperature T1 falls within the foregoing range, the particles of the positive electrode active material may have a suitable primary particle (the primary particles herein are primary particles of quasi-single-crystal particles) size, so that the positive electrode active material may have a good dynamic performance, and a part of the initial capacity of the positive electrode active material may be hidden. Therefore, the positive electrode active material may achieve an effect of a capacity slow-releasing agent, and thus, the cycle performance and the power performance of the battery may be improved.

When the first temperature T1 is relatively high, the dynamic performance of the prepared positive electrode active material is poor. When the first temperature T1 is relatively low, the prepared positive electrode active material has a good dynamic performance, but the initial capacity of the positive electrode active material may be sufficiently exerted. It is very difficult to subsequently perform excessive carbon coating. Therefore, it is very difficult for the prepared positive electrode active material to achieve an effect of a capacity slow-releasing agent, so that it is difficult for the battery using the positive electrode active material to have a long cycle life.

The first temperature T1 may range from 760°C to 820°C, and optionally range from 780°C to 820°C. Therefore, the cycle performance and the power performance of the battery may be further improved.

In some examples, the temperature may be increased to the first temperature T1 at a rate of 3°C/min to 8°C/min.

In some examples, the first time t1 may range from 8 h to 15 h, such as 8 h, 9 h, 10 h, 11 h, 12 h, 13 h, 14 h, 15 h, or a range composed of any of the foregoing values.

When the first time t1 falls within the foregoing range, the particles of the positive electrode active material may have a suitable primary particle (the primary particles herein are primary particles of quasi-single-crystal particles) size, so that the positive electrode active material may have a good dynamic performance, and a part of the initial capacity of the positive electrode active material may be hidden. Therefore, the positive electrode active material may achieve an effect of a capacity slow-releasing agent, and thus, the cycle performance and the power performance of the battery may be improved.

When the first time t1 is relatively long, the dynamic performance of the prepared positive electrode active material is poor. When the first time t1 is relatively short, the prepared positive electrode active material has a good dynamic performance, but the initial capacity of the positive electrode active material may be sufficiently exerted. It is very difficult to subsequently perform excessive carbon coating. Therefore, it is very difficult for the prepared positive electrode active material to achieve an effect of a capacity slow-releasing agent, so that it is difficult for the battery using the positive electrode active material to have a long cycle life.

Optionally, the first time t1 may range from 10 h to 14 h. Therefore, the cycle performance and the power performance of the battery may be further improved.

In some examples, a protective gas may include one or more of nitrogen, argon, and helium.

In some examples, when the second carbon coating layer is formed, the protective gas is always introduced into the chemical vapor deposition device. That is, the protective gas goes through a temperature increasing process, a temperature keeping process, and a temperature reducing process.

In some examples, the second temperature T2 may range from 600°C to 800°C, such as 600°C, 620°C, 640°C, 660°C, 680°C, 700°C, 720°C, 740°C, 760°C, 780°C, 800°C, or a range composed of any of the foregoing values.

When the second temperature T2 falls within the foregoing range, the positive electrode active material may have a good dynamic performance, the positive electrode active material may also better achieve an effect of a capacity slow-releasing agent, and thus, the cycle performance and the power performance of the battery may be better improved.

When the second temperature T2 is relatively high, the dynamic performance of the prepared positive electrode active material is poor. When the second temperature T2 is relatively low, the graphitization degree of the second carbon coating layer is relatively small, and the electronic conductivity of the second carbon coating layer is poor, so that the dynamic performance of the positive electrode active material is also affected.

Optionally, the second temperature T2 may range from 700°C to 800°C. Therefore, the cycle performance and the power performance of the battery may be further improved.

In some examples, the temperature may be increased to the second temperature T2 at a rate of 3°C/min to 8°C/min.

In some examples, the deposition gas may include carbon-containing organic small-molecule gases, such as, but not limited to one or more of acetylene, methane, ethylene, propylene, benzene, and toluene.

In some examples, a flow rate of the deposition gas is denoted as V, and a unit is L/min; a mass of the lithium-containing phosphate coated with a first carbon coating layer in the chemical vapor deposition device is denoted as m, and a unit is kg; and (V×t2)/m>0. A unit of the second time t2 is min.

In some examples, (V×t2)/m may range from 0.375 to 3.750, and range from 0.750 to 1.500.

By adjusting the flow rate of the deposition gas, the second time t2, and the mass m of the used lithium-containing phosphate coated with a first carbon coating layer to satisfy the foregoing relational expression, the content of the second carbon coating layer may be adjusted to be within a suitable range. In some examples, the weight content of the second carbon coating layer is denoted as w2%; and based on the total weight of the positive electrode active material, w2>0, optionally, 0.04≤w2≤0.40, more optionally, 0.06≤w2≤0.20, and further optionally, 0.07≤w2≤0.19.

In some examples, the chemical vapor deposition device may be a rotary furnace.

In some examples, the obtained positive electrode active material may further be crushed. The crushing treatment may be airflow crushing.

In some examples, the method includes the following steps: provide a lithium-containing phosphate precursor; grind the lithium-containing phosphate precursor and a first carbon source, a volume distribution particle size Dv50 of a ground material ranging from 350 nm to 500 nm; heat the ground material to 760°C to 850°C in a protective gas atmosphere and keep the ground material at this temperature for 8 h to 15 h to obtain a lithium-containing phosphate coated with a first carbon coating layer; place the obtained lithium-containing phosphate coated with a first carbon coating layer, having a mass m (unit: kg), into a chemical vapor deposition device and heat the obtained lithium-containing phosphate to 600°C to 800°C in the protective gas atmosphere, and introduce deposition gas, the flow rate being denoted as V (unit: L/min); and then, keep the obtained lithium-containing phosphate at this temperature for a second time t2 (unit: min) to enable the deposition gas to deposit to form a second carbon coating layer, so as to obtain a positive electrode active material, (V×t2)/m ranging from 0.375 to 3.750, and optionally ranging from 0.750 to 1.500. Therefore, the battery using the positive electrode active material has a long cycle life and a good power performance.

The positive electrode active material provided in the example of the present application may be prepared by the method provided in the example of the present application. Other parameters of the positive electrode active material can refer to the foregoing positive electrode active material, and details are not described herein again.

### [Positive electrode plate]

A positive electrode plate provided in the example of the present application includes a positive electrode current collector and a positive electrode film layer arranged on at least one surface of the positive electrode current collector. The positive electrode film layer includes the foregoing positive electrode active material, or the positive electrode active material prepared by the foregoing method.

The positive electrode current collector has two surfaces opposite in its own thickness direction, and the positive electrode film layer is arranged on either or both of the two opposite surfaces of the positive electrode current collector.

In some examples, the positive electrode film layer may further include another positive electrode active material other than the foregoing positive electrode active material or the positive electrode active material prepared by the foregoing method, for example, may further include a lithium transition metal oxide. This is not limited in the examples of the present application.

In some examples, the positive electrode film layer may further optionally include a positive electrode conductive agent. The type of the positive electrode conductive agent is not particularly limited in the present application. In some examples, for example, the positive electrode conductive agent may include one or more of superconducting carbon, conductive graphite, acetylene black, carbon black, Ketjen black, carbon dots, carbon nanotubes, graphene, and carbon nanofibers.

In some examples, the positive electrode film layer may further optionally include a positive electrode binder. The type of the positive electrode binder is not particularly limited in the present application. In some examples, for example, the positive electrode binder may include one or more of polyvinylidene fluoride (PVDF), polytetrafluoroethylene (PTFE), vinylidene fluoride-tetrafluoroethylene-propylene terpolymer, vinylidene fluoride-hexafluoropropylene-tetrafluoroethylene terpolymer, tetrafluoroethylene-hexafluoropropylene copolymer, and fluorine-containing acrylate resin.

In some examples, the positive electrode current collector may use a metal foil or a composite current collector. As an example of the metal foil, an aluminum foil may be used. The composite current collector may include a high molecular material substrate layer and a metal material layer formed on at least one surface of the high molecular material substrate layer. For example, a metal material may include one or more of aluminum, aluminum alloy, nickel, nickel alloy, titanium, titanium alloy, silver, and silver alloy. For example, the high molecular material substrate layer may include one or more of polypropylene (PP), polyethylene terephthalate (PET), polybutylene terephthalate (PBT), polystyrene (PS), and polyethylene (PE).

The positive electrode film layer is usually formed by applying the positive electrode slurry on the positive electrode current collector, and drying and cold-pressing the positive electrode slurry. The positive electrode slurry is usually formed by dispersing the positive electrode active material, the positive electrode binder, the positive electrode conductive agent and the like in a solvent, and stirring the components uniformly. The solvent may be N-methylpyrrolidone (NMP) or deionized water, but is not limited thereto.

### [Negative electrode plate]

The battery cell includes a negative electrode plate.

In some examples, the negative electrode plate includes a negative electrode current collector and a negative electrode film layer arranged on at least one surface of the negative electrode current collector, and the negative electrode film layer includes a negative electrode active material.

The negative electrode current collector has two surfaces opposite in its own thickness direction, and the negative electrode film layer is arranged on either or both of the two opposite surfaces of the negative electrode current collector.

In some examples, the negative electrode current collector may use a metal foil or a composite current collector. For example, as a metal foil, a copper foil may be used. The composite current collector may include a high molecular material substrate layer and a metal layer formed on at least one surface of the high molecular material substrate. The composite current collector may be formed by forming a metal material (such as copper, copper alloy, nickel, nickel alloy, titanium, titanium alloy, silver and silver alloy) on a high molecular material substrate (such as a substrate of polypropylene (PP), polyethylene terephthalate (PET), polybutylene terephthalate (PBT), polystyrene (PS), and polyethylene (PE)).

In some examples, the negative electrode active material may be a material well-known in the art. For example, the negative electrode active material may include one or more of the following materials: artificial graphite, natural graphite, soft carbon, hard carbon, a silicon-based material, a tin-based material, lithium titanate, and the like. The silicon-based material may include one or more of elemental silicon, a silicon-oxygen compound, a silicon-carbon composite, a silicon-nitrogen composite, and a silicon alloy. The tin-based material may include one or more of elemental tin, a tin-oxygen compound and a tin alloy. However, the present application is not limited to these materials, and other conventional materials that may be used as negative electrode active materials may also be used. Only one or a combination of two or more of these negative electrode active materials may be used.

In some examples, the negative electrode film layer may further optionally include a negative electrode binder. For example, the binder may include one or more of styrene-butadiene rubber (SBR), polyacrylic acid (PAA), sodium polyacrylate (PAAS), polyacrylamide (PAM), polyvinyl alcohol (PVA), sodium alginate (SA), polymethacrylic acid (PMAA), and carboxymethyl chitosan (CMCS).

In some examples, the negative electrode film layer may further optionally include a negative electrode conductive agent. For example, the conductive agent may include one or more of superconducting carbon, acetylene black, carbon black, Ketjen black, carbon dots, carbon nanotubes, graphene, and carbon nanofibers.

In some examples, the negative electrode film layer further optionally includes another adjuvant such as a thickener (for example, sodium carboxymethyl cellulose (CMC)).

In some examples, the negative electrode plate may be prepared as follows: the foregoing components for preparing the negative electrode plate, such as the negative electrode active material, the negative electrode conductive agent, the negative electrode binder and any other components, are dispersed into a solvent (such as deionized water) to form a negative electrode slurry; and the negative electrode slurry is coated on the negative electrode current collector, followed by processes such as drying and cold pressing, to obtain the negative electrode plate.

The negative electrode plate does not exclude other additional functional layers than the negative electrode film layer. For example, in some examples, the negative electrode plate may further include a conductive primer layer (which is, for example, formed by a conductive agent and a binder) sandwiched between the negative electrode current collector and the negative electrode film layer and arranged on the surface of the negative electrode current collector. In some examples, the negative electrode plate may further include a protective layer covering a surface of the negative electrode film layer.

### [Electrolyte]

The battery cell further includes an electrolyte. The electrolyte plays a role in conducting ions between the positive electrode plate and the negative electrode plate. The type of the electrolyte is not specifically limited in the present application, and may be selected according to requirements. For example, the electrolyte may include one or more of a solid electrolyte, a gel electrolyte, and a liquid electrolyte (i.e., an electrolyte solution).

In some examples, the electrolyte may use an electrolyte solution, and the electrolyte solution may include an electrolyte salt and a solvent.

The type of the electrolyte salt is not specifically limited, and may be selected according to actual requirements. In some examples, the electrolyte salt may include one or more of lithium hexafluorophosphate (LiPF₆), lithium tetrafluoroborate (LiBF₄), lithium perchlorate (LiClO₄), lithium hexafluoroarsenate (LiAsF₆), lithium bis(fluorosulfonyl)imide (LiFSI), lithium bis(trifluoromethanesulfonyl)imide (LiTFSI), lithium trifluoromethanesulfonate (LiTFS), lithium difluoro(oxalato)borate (LiDFOB), lithium bis(oxalato)borate (LiBOB), lithium difluorophosphate (LiPO₂F₂), lithium difluoro(oxalato)phosphate (LiDFOP), and lithium tetrafluoro(oxalato)phosphate (LiTFOP).

The type of the solvent is not specifically limited, and may be selected according to actual requirements. In some examples, for example, the solvent may include one or more of ethylene carbonate (EC), propylene carbonate (PC), ethyl methyl carbonate (EMC), diethyl carbonate (DEC), dimethyl carbonate (DMC), dipropyl carbonate (DPC), methyl propyl carbonate (MPC), ethyl propyl carbonate (EPC), butylene carbonate (BC), fluoroethylene carbonate (FEC), methyl formate (MF), methyl acetate (MA), ethyl acetate (EA), propyl acetate (PA), methyl propionate (MP), ethyl propionate (EP), propyl propionate (PP), methyl butyrate (MB), ethyl butyrate (EB), 1,4-butyrolactone (GBL), sulfolane (SF), methylsulfonylmethane (MSM), ethyl methyl sulfone (EMS), and ethylsulfonylethane (ESE).

In some examples, the electrolyte solution further optionally includes an additive. For example, the additive may include a negative electrode film-forming additive, a positive electrode film-forming additive, or an additive capable of improving certain performance of the battery, such as an additive capable of improving overcharging performance of the battery, an additive capable of improving high temperature performance of the battery, or an additive capable of improving low temperature power performance of the battery.

### [Separator]

The battery cell may further include a separator. The separator may be arranged between the positive electrode plate and the negative electrode plate to mainly play a role in preventing an internal short circuit. The type of the separator is not particularly limited in the present application, and any well-known separator with a porous structure having good chemical stability and mechanical stability may be selected.

In some examples, a material of the separator may include one or more of glass fiber, nonwoven fabric, polyethylene, polypropylene, polyvinylidene fluoride, and polyimide. The separator may be a single-layer film or a multi-layer composite film. When the separator is a multi-layer composite film, materials of the layers are the same or different.

The preparation method of the battery cell is well-known. In some examples, the positive electrode plate, the separator, the negative electrode plate, and the electrolyte solution may be assembled into a battery cell. For example, the positive electrode plate, the separator, and the negative electrode plate may be assembled into an electrode assembly by a winding process and/or a stacking process, the electrode assembly is placed into an outer package, dried and then injected with the foregoing electrolyte solution, and processes, such as vacuum encapsulation, standing and formation, are performed to obtain a battery cell. A plurality of battery cells may further be connected in series, parallel or series and parallel to form a battery module. A plurality of battery modules may further be connected in series, parallel or series and parallel to form a battery pack. In some examples, a plurality of battery cells may further be directly assembled into a battery pack.

An example of the present application further provides a power consuming apparatus. The power consuming apparatus includes the battery provided in the example of the present application. The battery may be used as a power source of the power consuming apparatus, or may be used as an energy storage unit of the power consuming apparatus. The power consuming apparatus may be, but is not limited to, a mobile device (for example, a mobile phone, a tablet, or a laptop), an electric vehicle (for example, an all-electric vehicle, a hybrid electric vehicle, a plug-in hybrid electric vehicle, an electric bicycle, an electric scooter, an electric golf cart, or an electric truck), an electric train, a ship and a satellite, an energy storage system, or the like.

The type of the battery may be selected for the power consuming apparatus according to the use requirement of the power consuming apparatus. For example, a battery cell, a battery module, or a battery pack may be selected.

FIG. 6 is a schematic diagram of a power consuming apparatus as an example. The power consuming apparatus is an all-electric vehicle, a hybrid electric vehicle, a plug-in hybrid electric vehicle, or the like. To meet the requirements of the power consuming apparatus for high power and high energy density, a battery pack or a battery module may be used.

For another example, the power consuming apparatus may be a mobile phone, a tablet, a laptop, or the like. The power consuming apparatus usually needs to be light and thin, and a battery cell may be used as a power source.

### Examples

The content disclosed in the present application is described in detail in the following examples. These examples are only for illustrative purposes, as various modifications and changes made without departing from the scope of the content disclosed in the present application are apparent to those skilled in the art. Unless otherwise specified, all parts, percentages, and ratios described in the following examples are based on weight, all reagents used in the examples are commercially available or synthesized according to conventional methods and can be directly used without further treatment, and all instruments used in the examples are commercially available.

### Example 1

### (1) Preparation of positive electrode plate

### Preparation of positive electrode active material:

Mix FePO₄, Li₂CO₃ and a first carbon source glucose uniformly, add a small amount of water to the mixture, and grind the mixture until a volume distribution particle size Dv50 is 400 nm and then perform spray-drying. Place a powder obtained by spray-drying into a sintering furnace, heat the powder to 780°C (first temperature T1) at 5°C/min in a nitrogen atmosphere and keep the powder at this temperature for 10 h (first time t1), and then cool the product to obtain a lithium-containing phosphate coated with a first carbon coating layer. The added amount of the first carbon source is based on the total weight of the prepared positive electrode active material, and a weight content of a residual carbon of the first carbon source (that is, the weight content w1% of the first carbon coating layer) is 1.25%.

Place 8 kg of the lithium-containing phosphate coated with a first carbon coating layer (denoted as m) into a rotary furnace, and introduce nitrogen at a flow rate of 4 L/min throughout a temperature increasing process, a temperature keeping process, and a temperature reducing process. Heat the lithium-containing phosphate to 750°C (second temperature T2) at 5°C/min, and keep this temperature for 15 min (second time t2). Introduce acetylene gas (deposition gas) in the temperature keeping process, the gas flow rate V being 0.40 L/min. After the temperature keeping process is completed, stop introducing the acetylene gas, and then, cool the product naturally and crush the product by airflow to obtain LiFePO₄ coated with two carbon coating layers. Based on the total weight of the prepared positive electrode active material, the weight content w2% of the second carbon coating layer is 0.09%.

### Preparation of positive electrode plate:

Mix the foregoing positive electrode active material (LiFePO₄ coated with two carbon coating layers), carbon black SP, and polyvinylidene fluoride (PVDF) uniformly in an N-methylpyrrolidone solvent system according to a weight ratio of 92:2.5:5.5, and then, coat the mixture ion an aluminum foil and dry and cold-press the mixture to obtain a positive electrode plate.

### (2) Preparation of negative electrode plate

Mix negative electrode active materials graphite, acetylene black, styrene-butadiene rubber (SBR), and sodium carboxymethyl cellulose (CMC) are uniformly in deionized water according to a weight ratio of 95:2:2:1, and then, coat the mixture on a copper foil and dry and cold-press the mixture to obtain a negative electrode plate.

### (3) Separator

A polyethylene (PE) porous film is used as a separator.

### (4) Electrolyte solution

A solution of 1 mol/L LiPF6 in ethylene carbonate (EC), diethyl carbonate (DEC), and ethyl methyl carbonate (EMC) at a volume ratio of 1:1:1 is used as an electrolyte solution.

### (5) Preparation of battery

Stack the positive electrode plate, the separator, and the negative electrode plate in sequence, so as to enable the separator to be located between the positive and negative electrodes to achieve an effect of isolation, and wind the positive electrode plate, the separator, and the negative electrode plate to obtain an electrode assembly. Place the electrode assembly into an outer package, inject the electrolyte solution and perform encapsulation, and then perform processes, such as formation, to obtain a battery.

### Examples 2 to 14 and Comparative Examples 1 to 3

The preparation method of the battery is similar to that in Example 1, and the difference lies in that process parameters for preparing the positive electrode active material are different, which are specifically shown in Table 1 and Table 2.

In Table 1, "/" indicates that this step is not performed.

In Table 2, w1% indicates the weight content of the first carbon coating layer (that is, a residual carbon value of the first carbon source) based on the total weight of the prepared positive electrode active material; and w2% indicates the weight content of the second carbon coating layer based on the total weight of the prepared positive electrode active material.

### Performance test

### (1) Test of charge capacity per gram of positive electrode active material

The charge capacity per gram of the positive electrode active material is obtained by assembling a button battery and then charging the button battery.

Preparation of button battery: Use a lithium metal sheet as a counter electrode, and assemble the lithium metal sheet together with the positive electrode plates and electrolyte solutions prepared in the foregoing examples and comparative examples in a button battery box to form a button battery.

At 25°C, allow the foregoing prepared button battery to stand for 3 h, charge the prepared button battery to 3.75 V at a constant current of 0.1 C, then charge the prepared button battery to 50 µA at a constant voltage, allow the prepared button battery to stand for 5 min, and record a charge capacity of the button battery at 25°C. Charge capacity C1 per gram of positive electrode active material at 25°C=charge capacity of button battery at 25°C / mass of positive electrode active material.

At 60°C, allow the foregoing prepared button battery to stand for 3 h, charge the prepared button battery to 3.75 V at a constant current of 0.1 C, then charge the prepared button battery to 50 µA at a constant voltage, allow the prepared button battery to stand for 5 min, and record the charge capacity of the button battery at 60°C. Charge capacity C2 per gram of positive electrode active material at 60°C=charge capacity of button battery at 60°C / mass of positive electrode active material.

### (2) Cycle performance test of battery

At 25°C, allow the batteries prepared in the foregoing examples and comparative examples to stand for 30 min and then perform following tests: Charge the battery to 3.65 V at a constant power of 0.5 P; and after the battery is allowed to stand for 10 min, discharge the battery to 2.5 V at a constant power of 0.5 P. Repeat the foregoing steps until the discharge capacity of the battery fades to 90% of the discharge capacity of the first circle of the battery, and record the number of cycles of the battery.

### (3) Initial direct current internal resistance test of battery

At 25°C, charge the batteries prepared in the foregoing examples and comparative examples to 3.65 V at a constant current of 0.5 C and then charge the batteries at a constant voltage until the current is 0.05 C; discharge the battery for 60 min at a constant current of 0.5 C to adjust the battery to 50% of SOC, and at this time, denote the voltage of the battery as U1; and discharge the battery for 30 s at a constant current of 1 C with a sampling point of 0.1 s, and denote the voltage at the end of discharge as U2. The discharge DCR of the battery at 50% of SOC indicates initial direct current internal resistance DCR of the battery, where DCR=(U1-U2)/1C.

Table 2 shows test results of the foregoing examples and comparative examples.

**Table 1**

| Serial number | Dv50 of ground lithium-containing phosphate precursor (nm) | Coated with first carbon coating layer | | Coated with second carbon coating layer | | | | | |
|---|---|---|---|---|---|---|---|---|---|
| | | First temperature T1 (°C) | First time t1 (h) | Second temperature T2 (°C) | Second time t2 (min) | Deposition gas | Deposition gas flow rate V (L/min) | m (kg) | (V×t2)/m |
| Example 1 | 400 | 780 | 10 | 750 | 15 | Acetylene | 0.40 | 8 | 0.750 |
| Example 2 | 400 | 780 | 10 | 750 | 15 | Acetylene | 0.10 | 4 | 0.375 |
| Example 3 | 400 | 780 | 10 | 700 | 30 | Acetylene | 0.40 | 8 | 1.500 |
| Example 4 | 400 | 760 | 10 | 750 | 15 | Acetylene | 0.20 | 4 | 0.750 |
| Example 5 | 400 | 790 | 10 | 750 | 15 | Propylene | 0.50 | 10 | 0.750 |
| Example 6 | 400 | 820 | 14 | 750 | 15 | Acetylene | 0.40 | 8 | 0.750 |
| Example 7 | 400 | 780 | 10 | 750 | 15 | Ethylene | 0.25 | 1 | 3.750 |
| Example 8 | 400 | 850 | 10 | 750 | 15 | Acetylene | 0.40 | 8 | 0.750 |
| Example 9 | 400 | 780 | 10 | 800 | 15 | Acetylene | 0.30 | 6 | 0.750 |
| Example 10 | 400 | 780 | 10 | 700 | 15 | Acetylene | 0.30 | 6 | 0.750 |
| Example 11 | 400 | 780 | 10 | 600 | 15 | Acetylene | 0.30 | 6 | 0.750 |
| Example 12 | 500 | 780 | 10 | 750 | 15 | Acetylene | 0.40 | 8 | 0.750 |
| Example 13 | 450 | 780 | 10 | 750 | 15 | Acetylene | 0.40 | 8 | 0.750 |
| Example 14 | 350 | 780 | 10 | 750 | 15 | Acetylene | 0.40 | 8 | 0.750 |
| Comparative example 1 | 400 | 780 | 10 | / | / | / | / | / | / |
| Comparative example 2 | 300 | 780 | 10 | 750 | 15 | Acetylene | 0.40 | 8 | 0.750 |
| Comparative example 3 | 400 | 740 | 6 | 750 | 15 | Acetylene | 0.40 | 8 | 0.750 |

**Table 2**

| Serial number | Positive electrode active material | | | | | | | | Number of cycles of battery | Initial direct current internal resistance DCR of battery (mΩ) |
|---|---|---|---|---|---|---|---|---|---|---|
| | w1% | w2% | w1%+w2% | w2/w1 | Dv50 (µm) | C1 (mAh/g) | C2 (mAh/g) | C2/C 1 | | |
| Example 1 | 1.25% | 0.09% | 1.34% | 0.072 | 1.8 | 155.5 | 162.1 | 1.042 | 3255 | 31.7 |
| Example 2 | 1.25% | 0.04% | 1.29% | 0.032 | 1.3 | 158.8 | 162.8 | 1.025 | 2898 | 31.9 |
| Example 3 | 1.25% | 0.19% | 1.44% | 0.152 | 1.8 | 149.7 | 161.3 | 1.077 | 4279 | 32.0 |
| Example 4 | 1.06% | 0.08% | 1.14% | 0.075 | 1.0 | 156.7 | 162.4 | 1.036 | 3208 | 31.6 |
| Example 5 | 1.37% | 0.11% | 1.48% | 0.080 | 1.7 | 152.5 | 161.8 | 1.061 | 3468 | 32.1 |
| Example 6 | 1.13% | 0.07% | 1.20% | 0.062 | 1.9 | 153.4 | 161.1 | 1.050 | 3389 | 35.9 |
| Example 7 | 1.25% | 0.30% | 1.55% | 0.240 | 2.3 | 144.0 | 160.5 | 1.115 | 4985 | 32.3 |
| Example 8 | 1.38% | 0.09% | 1.47% | 0.065 | 1.7 | 149.8 | 159.6 | 1.065 | 3509 | 36.7 |
| Example 9 | 1.25% | 0.08% | 1.33% | 0.064 | 2.3 | 153.8 | 161.9 | 1.053 | 3402 | 34.5 |
| Example 10 | 1.25% | 0.09% | 1.34% | 0.072 | 1.9 | 155.7 | 162.3 | 1.042 | 3267 | 31.6 |
| Example 11 | 1.25% | 0.10% | 1.35% | 0.080 | 1.6 | 154.1 | 161.9 | 1.051 | 3301 | 32.2 |
| Example 12 | 1.13% | 0.09% | 1.22% | 0.080 | 2.0 | 154.9 | 159.7 | 1.031 | 3321 | 35.2 |
| Example 13 | 1.19% | 0.09% | 1.28% | 0.076 | 1.8 | 155.1 | 161.1 | 1.039 | 3299 | 33.4 |
| Example 14 | 1.27% | 0.10% | 1.37% | 0.079 | 1.6 | 157.8 | 162.2 | 1.028 | 2902 | 30.1 |
| Comparative example 1 | 1.25% | / | / | / | 1.6 | 161.7 | 163.1 | 1.009 | 2004 | 31.7 |
| Comparative example 2 | 1.33% | 0.10% | 1.43% | 0.075 | 1.0 | 162.0 | 162.5 | 1.003 | 1893 | 30.0 |
| Comparative example 3 | 1.29% | 0.10% | 1.39% | 0.078 | 2.1 | 161.3 | 162.1 | 1.005 | 1906 | 37.6 |

It can be known from the test results of Table 1 and Table 2 that by adjusting the ratio C2/C1 of the charge capacity C1 per gram of the positive electrode active material at 25°C to the charge capacity C2 per gram of the positive electrode active material at 60°C to be greater than or equal to 1.020, the battery may have a longer cycle life.

It can be further known from the test results of Table 1 and Table 2 that by adjusting the ratio C2/C1 of the charge capacity C1 per gram of the positive electrode active material at 25°C to the charge capacity C2 per gram of the positive electrode active material at 60°C to satisfy 1.025≤C2/C1≤1.115, and optionally satisfy 1.031≤C2/C1≤1.061, the battery has a long cycle life and a high initial capacity while having a relatively low internal resistance and a good dynamic performance.

It should be noted that the present application is not limited to the foregoing embodiments. The foregoing embodiments are merely exemplary, and embodiments having substantially the same technical idea and the same effects within the scope of the technical solution of the present application are all included in the technical scope of the present application. In addition, other embodiments constructed by applying various modifications conceivable to those skilled in the art to the embodiments and combining some of the constituent elements of the embodiments without departing from the scope of the essence of the present application are also included in the scope of the present application.

## Claims

1. A positive electrode active material, wherein the positive electrode active material comprises a lithium-containing phosphate, a charge capacity per gram of the positive electrode active material at 25°C is denoted as C1, the charge capacity per gram of the positive electrode active material at 60°C is denoted as C2, both units are mAh/g, and C2/C1≥1.020.

2. The positive electrode active material according to claim 1, wherein 1.025≤C2/C1≤1.115, and optionally, 1.031≤C2/C1≤1.061.

3. The positive electrode active material according to any one of claims 1 to 2, wherein at least a part of a surface of the lithium-containing phosphate has a carbon coating layer; and
optionally, the carbon coating layer comprises a first carbon coating layer and a second carbon coating layer, and the first carbon coating layer is located between the lithium-containing phosphate and the second carbon coating layer.

4. The positive electrode active material according to claim 3, wherein
a weight content of the first carbon coating layer is denoted as w1%, and based on a total weight of the positive electrode active material, 0.5≤w1≤2.0, and optionally, 1.06≤w1≤1.38; and/or
a weight content of the second carbon coating layer is denoted as w2%, and based on the total weight of the positive electrode active material, w2>0, optionally, 0.04≤w2≤0.40, and more optionally, 0.07≤w2≤0.19.

5. The positive electrode active material according to any one of claims 3 to 4, wherein
the weight content of the first carbon coating layer is denoted as w1%, the weight content of the second carbon coating layer is denoted as w2%, and both based on the total weight of the positive electrode active material,
1.14≤w1+w2≤1.55, and optionally, 1.20≤w1+w2≤1.48; and/or
0.030≤w2/w1≤0.240, and optionally, 0.072≤w2/w1≤0.152.

6. The positive electrode active material according to any one of claims 3 to 5, wherein
the first carbon coating layer comprises pyrolytic carbon formed by way of pyrolysis, and the second carbon coating layer comprises chemical vapor deposition carbon formed by way of chemical vapor deposition; and/or
a graphitization degree of the first carbon coating layer is less than a graphitization degree of the second carbon coating layer.

7. The positive electrode active material according to any one of claims 1 to 6, wherein the positive electrode active material is of a single-crystal structure or a quasi-single-crystal structure.

8. The positive electrode active material according to any one of claims 1 to 7, wherein a volume distribution particle size Dv50 of the positive electrode active material ranges from 0.5 µm to 2.5 µm, and optionally ranges from 1.3 µm to 1.9 µm.

9. The positive electrode active material according to any one of claims 1 to 8, wherein
145 mAh/g≤C1≤162 mAh/g, and optionally, 152.5 mAh/g≤C1≤156.7 mAh/g; and/or
158 mAh/g≤C2≤167 mAh/g, and optionally, 160.0 mAh/g≤C2≤162.8 mAh/g.

10. The positive electrode active material according to any one of claims 1 to 9, wherein the lithium-containing phosphate comprises one or more of lithium iron phosphate and doped modified compounds thereof; optionally, the lithium-containing phosphate comprises a material with a molecular formula LiₘAₓFe_{1-y}B_{y}P_{1-z}C_{z}O₄₋ₙDₙ, wherein A comprises one or more elements of Zn, AI, Na, K, and Mg; B comprises one or more elements of Cu, Mn, Cr, Zn, Pb, Ca, Co, Ni, Sr, Nb, and Ti; C comprises one or more elements of B, S, Si, and N; D comprises one or more elements of S, F, Cl, and Br; m is selected from a range of 0.5 to 1.15, and is optionally selected from a range of 0.95 to 1.05; x is selected from a range of 0 to 0.1, and is optionally selected from a range of 0.001 to 0.005; y is selected from a range of 0 to 0.5, and is optionally selected from a range of 0.001 to 0.1; z is selected from a range of 0 to 0.5, and is optionally selected from a range of 0.001 to 0.1; and n is selected from a range of 0 to 0.5, and is optionally selected from a range of 0.001 to 0.1.

11. A preparation method of a positive electrode active material, comprises the following steps:
providing a lithium-containing phosphate precursor;
grinding the lithium-containing phosphate precursor and a first carbon source, heating a ground material to a first temperature T1 in a protective gas atmosphere, and keeping the ground material at the first temperature T1 for a first time t1 to obtain a lithium-containing phosphate coated with a first carbon coating layer; and
placing the obtained lithium-containing phosphate coated with a first carbon coating layer in a chemical vapor deposition device, heating the chemical vapor deposition device to a second temperature T2 in the protective gas atmosphere, introducing deposition gas, and then, keeping the chemical vapor deposition device at the second temperature T2 for a second time t2 to enable the deposition gas to deposit to form a second carbon coating layer, so as to obtain a positive electrode active material, wherein
the positive electrode active material comprises the lithium-containing phosphate, a charge capacity per gram of the positive electrode active material at 25°C is denoted as C1, the charge capacity per gram of the positive electrode active material at 60°C is denoted as C2, both units are mAh/g, and C2/C1≥1.020.

12. The preparation method according to claim 11, wherein in the step of grinding the lithium-containing phosphate precursor and a first carbon source, a volume distribution particle size Dv50 of the ground material ranges from 350 nm to 500 nm, and optionally ranges from 350 nm to 450 nm.

13. The preparation method according to any one of claims 11 to 12, wherein
the first temperature T1 ranges from 760°C to 850°C, and optionally ranges from 780°C to 820°C; and/or
the first time t1 ranges from 8 h to 15 h, and optionally ranges from 10 h to 14 h; and/or
the second temperature T2 ranges from 600°C to 800°C, and optionally ranges from 700°C to 800°C.

14. The preparation method according to any one of claims 11 to 13, wherein a flow rate of the deposition gas is denoted as V, and a unit is L/min; a mass of the lithium-containing phosphate coated with a first carbon coating layer in the chemical vapor deposition device is denoted as m, and a unit is kg; and (V×t2)/m>0, and a unit of the second time t2 is min; and
optionally, (V×t2)/m ranges from 0.375 to 3.750, and more optionally ranges from 0.750 to 1.500.

15. The preparation method according to any one of claims 11 to 14, wherein
the first carbon source comprises one or more of glucose, sucrose, lactose, maltose, starch, cellulose, asphalt, polyethylene glycol, and carbon black; and/or
the deposition gas comprises one or more of acetylene, methane, ethylene, propylene, benzene, and toluene; and/or
the protective gas comprises one or more of nitrogen, argon, and helium.

16. A battery cell, comprising a positive electrode plate, the positive electrode plate comprising a positive electrode current collector and a positive electrode film layer arranged on at least one surface of the positive electrode current collector, wherein the positive electrode film layer comprises the positive electrode active material according to any one of claims 1 to 10, or the positive electrode active material prepared by the preparation method according to any one of claims 11 to 15.

17. A power consuming apparatus, comprising the battery cell according to claim 16.
